(19) Europäisches Patentamt
European Patent Office
Office européen des brevets

(11) Publication number: **0 000 830**
**B1**

(12) **EUROPEAN PATENT SPECIFICATION**

(45) Date of publication of patent specification: **09.12.81**

(21) Application number: **78300234.8**

(22) Date of filing: **02.08.78**

(51) Int. Cl.³: **H 01 L 31/06,** H 01 L 29/28 //H01L31/02

(54) **Photovoltaic elements.**

(30) Priority: **02.08.77 US 821117**
**13.03.78 US 885926**

(43) Date of publication of application:
**21.02.79 Bulletin 79/4**

(45) Publication of the grant of the European patent:
**09.12.81 Bulletin 81/49**

(84) Designated Contracting States:
**BE CH DE FR GB**

(56) References cited:
**US - A - 3 057 947**
**US - A - 3 250 615**
**US - A - 3 507 706**
**US - A - 3 615 414**
**US - A - 3 615 415**
**US - A - 3 679 407**
**US - A - 3 706 554**
**US - A - 3 900 945**
**US - A - 3 938 994**

**IBM TECHNICAL DISCLOSURE BULLETIN, vol. 18, nr. 8, January 1976, New York**

(73) Proprietor: **EASTMAN KODAK COMPANY**
**343 State Street**
**Rochester, New York 14650 (US)**

(72) Inventor: **Tang, Ching Wan**
**138, Falmouth Street**
**Rochester New York (US)**
Inventor: **Marchetti, Alfred Paul**
**227 Henderson Drive**
**Renfield New York (US)**
Inventor: **Young, Ralph Howard**
**270 Cobb Terrace**
**Rochester New York (US)**

(74) Representative: **Trangmar, Leigh Alan**
**P.O. Box 114 246 High Holborn**
**London WC1V 7EA (GB)**

(56) References cited:
**R.L. GAMBLIN & D.B. SCLOVE "Solar cell utilizing organic photoconductor," page 2442**

**JOURNAL OF HETEROCYCLIC CHEMISTRY, vol. 9, October 1972, Provo (US)**
**G.A. REYNOLDS & J.A. VAN ALLAN "The reactions of pyranylidenemethylpyrylium salts with sodium sulfide," pages 1105—1107**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 000 830 B1**

# Photovoltaic elements

This invention relates to photovoltaic elements useful for converting light, and particularly for converting solar energy, into electrical energy.

Materials most widely used in the past for solar cells have been inorganic semiconductors, due to their fairly high conversion efficiencies which have been as high as 12 to 15%, for example, for silicon. However, such solar cells have proven to be very expensive to construct due to the melt and other processing techniques necessary to fabricate the semiconductor layer. As a result, such cells have had extensive practical utility only in the field of space exploration, and not in terrestrial applications.

In an effort to reduce the cost of solar cells, organic photoconductor and semiconductor layers have been considered due to their inexpensive formation by solvent coating and similar techniques. However, prior-art organic photoconductors have provided solar cells with conversion efficiencies only as high as about 0.05% at their highest when exposed to incident sunlight at an intensity of 100 mw/cm$^2$. An example of such a material is crystal violet, as described, for example, in U.S. Patent No. 3,844,843. Higher efficiencies are desirable if the cells are to have practical terrestrial use, notwithstanding their inexpensive cost of manufacture. An efficiency of 0.3% was reported as being achieved through the use of an undisclosed dopant, as noted in "Prospects for Direct Conversion of Solar Energy to Electricity," L.W. Davies, AWA Technical Review, Vol. 15, No. 4, 1974, 139—142 reference 3.

U.S. Specification 3,507,706 describes photovoltaic cells in which a photosensitive layer comprising a charge transfer complex of poly-N-vinylcarbazole and iodine is used. Poly-N-vinylcarbazole by itself is a known organic photoconductor. The photovoltaic cells described exhibit low voltages in the range 2—20 mV.

Solar cells utilizing other organic photoconductors are disclosed in U.S. Patent Nos. 3,009,006; 3,057,947 and 3,530,007 and *IBM Technical Disclosure Bulletin 18* (8), No. 2442 (January 1976).

The present invention provides a photovoltaic element having enhanced electrical response to incident light.

According to the present invention there is provided a photovoltaic element which comprises a photoconductive layer comprising an electrically insulating binder, a pyrylium-type dye salt and an organic photoconductor having an electrical conductor adjacent each of the surfaces of the layer, at least one of the conductors being transparent to electromagnetic radiation to which the element is sensitive.

Although the invention is hereinafter described particularly with respect to solar cells as the preferred embodiment, it is not limited thereto; rather it applies to all photovoltaic elements. As used herein, "photovoltaic element" means a solid-state device which converts radiation absorbed by the element directly to electric power. Thus, the element of this invention is suitable as a terrestrial rooftop generator or as a light-level measuring device. As a light-level measuring device, the element may be used both at high and low light levels. The element exhibits a moderately high open-circuit voltage, even in diffuse roomlight conditions.

Alternatively, the element can also be used in the current mode. The current generated in a diffuse room-light condition is about 20$\mu$ A/cm$^2$, a large enough current to be measured accurately. The current can thus become a measure of the light intensity. The element can be calibrated to show light intensity as a function of the amount of current generated and thus the element can be used as an exposure meter in cameras.

The photovoltaic elements of the present invention are capable of working at conversion efficiencies of above 0.05%.

The photoconductive layer of the element comprises an electrically insulating binder, a pyrylium type dye salt and an organic photoconductor. Prior to, during, or after coating this layer, it is preferably processed in such a way as to normally obtain "aggregate" formation, i.e., the presence in the photoconductive layer of a discontinuous phase composed of a particulate co-crystalline complex of the binder and dye dispersed in a continuous phase of the binder and photoconductor. Such processing is hereinafter termed "aggregate processing." In some instances, certain dyes will not form aggregate, however, the photoconductive layer will perform in the same manner as if aggregate formation occurred.

A wide range of film-forming resins may be employed for the insulating binder. For example, in the case of many of the dyes of structure (I) hereinafter described, a wide variety of binders can be used ranging from polystyrene to polycarbonates such as those described more fully hereinafter. Highly useful for one class of dyes, shown as structure (II) hereafter described, are polymers containing an alkylidene diarylene portion in the recurring unit such as those prepared with Bisphenol A and including polymeric products of ester exchange between diphenylcarbonate and 2,2-bis-(4-hydroxyphenyl)propane. Such polymers are disclosed in the following U.S. Patents: U.S. Patent No. 2,999,750 by Miller et al, issued September 12, 1961; U.S. Patent No. 3,038,874 by Laakso et al, issued June 12, 1962; U.S. Patent No. 3,106,544 by Laakso et al, issued October 8, 1963; U.S. Patent No. 3,106,545 by Laakso et al, issued October 8, 1963; and U.S. Patent No. 3,106,546 by Laakso et al,

issued October 8, 1963. Many film-forming polycarbonate resins are useful, with completely satisfactory results being obtained when using commercial resins which are characterized by an inherent viscosity of between 0.5 and 3.0 measured at a concentration of 0.25 g in 1 dl of a 1:1 by weight phenol/chlorobenzene solvent mixture at 25°C. If the photoconductive layer is to be formed by spin-coating, then the higher-molecular-weight polycarbonates are preferred, such as Bisphenol A polycarbonates with inherent viscosities (measured as above) of 1.5 to 3.0. The following polycarbonates and polythiocarbonates listed in Table I are illustrative of those that can be used.

TABLE I

| Number | Polymeric Material |
|---|---|
| 1 | Poly(4,4′-isopropylidenediphenylene-co-1,4-cyclohexyldimethylene carbonate). |
| 2 | Poly(3,3′-ethylenedioxyphenylene thiocarbonate). |
| 3 | Poly(4,4′-isopropylidenediphenylene carbonate-co-terephthalate). |
| 4 | Poly(4,4′-isopropylidenediphenylene carbonate). |
| 5 | Poly(4,4′-isopropylidenediphenylene thiocarbonate). |
| 6 | Poly[2,2-butanebis(4-phenylene) carbonate]. |
| 7 | Poly(4,4′-isopropylidenediphenylene carbonate-block-ethylene oxide). |
| 8 | Poly(4,4′-isopropylidenediphenylene carbonate-block-tetramethyleneoxide). |
| 9 | Poly[4,4′-isopropylidenebis(2-methylphenylene) carbonate]. |
| 10 | Poly(4,4′-isopropylidenediphenylene-co-1,4-phenylene carbonate). |
| 11 | Poly(4,4′-isopropylidenediphenylene-co-1,3-phenylene carbonate). |
| 12 | Poly(4,4′-isopropylidenediphenylene-co-4,4′-biphenylidene carbonate). |
| 13 | Poly(4,4′-isopropylidenediphenylene-co-4,4′-oxydiphenylene carbonate). |
| 14 | Poly(4,4′-isopropylidenediphenylene-co-4,4′-carbonyldiphenylene carbonate). |
| 15 | Poly(4,4′-isopropylidenediphenylene-co-4,4′-ethylenediphenylene carbonate). |
| 16 | Poly[4,4′-methylenebis(2-methylphenylene)carbonate]. |
| 17 | Poly[1,1-(p-bromophenylethane)bis(1,4-phenylene) carbonate]. |
| 18 | Poly[4,4′-isopropylidenediphenylene-co-sulfonylbis(4-phenylene) carbonate]. |
| 19 | Poly[1,1-cyclohexanebis(1,4-phenylene) carbonate]. |
| 20 | Poly[4,4′-isopropylidenebis(2-chlorophenylene) carbonate]. |
| 21 | Poly(hexafluoroisopropylidene di-1,4-phenylene carbonate). |
| 22 | Poly[4,4′-(3-methyl-2-butylidene)bisphenylene carbonate]. |
| 23 | Poly[4,4′-(3,3-dimethyl-2-butylidene) bisphenylene carbonate]. |
| 24 | Poly[4,4′-(naphthylidene)diphenylene carbonate]. |
| 25 | Poly(4,4′-(4-methyl-2-pentylidene)bisphenylene carbonate]. |
| 26 | Poly[4,4′-(2-norbornylidene)diphenylene carbonate]. |
| 27 | Poly[4,4′-(hexahydro-4,7-methanoindan-5-ylidene)diphenylene carbonate]. |

TABLE I (continued)

| Number | Polymeric Material |
|---|---|
| 28 | Poly(4,4'-isopropylidenediphenylene carbonate-block-oxytetramethylene). |
| 29 | Poly[4,4'-(2-norbornylidene)bis(2,6-dichlorophenylene) carbonate]. |

In addition to the aforesaid polycarbonate binders, a variety of other binders may be used, particularly with the dyes of the structure (I) described below. Examples of such other binders are poly[4,4 - hexahydro - 4,7 - methanoindan - 5 - ylidene)diphenylene terephthalate]; poly[4,4'-(isopropylidene)diphenylene - 4,4' - oxydibenzoate; and polystyrene.

A pyrylium-type dye salt is used as the dye portion of the composition. Included within the term are dyes containing a pyrylium, thiapyrylium or selenapyrylium nucleus, and also dyes containing condensed ring systems such as benzopyrylium and naphthopyrylium nuclei.

A preferred class of pyrylium-type dye salts comprises those having the structure:

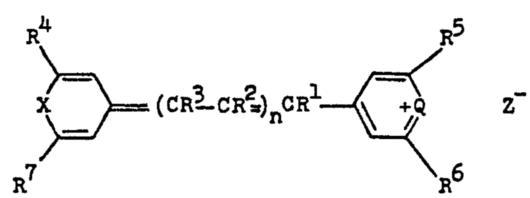

(I)

wherein

$R^1$, $R^2$ and $R^3$ are the same or different and are each hydrogen atoms or aryl, substituted aryl, alkyl containing from 1 to 6 carbon atoms, cyano or nitro groups,

X and Q are the same or different and are each oxygen, sulphur or selenium atoms,

n is 1 or 0,

$R^4$, $R^5$, $R^6$ and $R^7$ are the same or different and are each a phenyl or substituted phenyl group or an alkyl or alkoxy group containing from 1 to 5 carbon atoms, at least two of the groups $R^4$, $R^5$, $R^6$ and $R^7$ being phenyl groups, and

$Z^-$ is an anion.

Examples of groups which $R^1$, $R^2$ and $R^3$ may represent are methyl, ethyl, propyl, isopropyl, phenyl, cyano and nitro.

Examples of groups which $R^4$, $R^5$, $R^6$ and $R^7$ may represent are phenyl, methyl, ethyl, isopropyl, methoxy and propoxy.

Examples of anions Z are perchlorate, fluoroborate and sulphate.

If $R^4$, $R^5$, $R^6$ or $R^7$ are substituted phenyl groups, it is preferred that the substituents be located in the *para* position and be selected from among those which shift the blue absorption peak of the dye to a longer wavelength. Examples of such substituents include alkyl from 1 to 3 carbon atoms, and halogen, e.g., chlorine or fluorine.

Highly useful and currently preferred examples of dye salts within structure (I) are those wherein X and Q are either S and O; S and S; Se and O; or S and Se respectively, and $R^2$ and $R^3$ are hydrogen.

Some dye salts of structure (I) do not form visually observable "aggregate" particles of dye salt and binder as described above when processed as described hereinafter. Compounds 39 and 40 of Table II below are processed as though such aggregation does occur. That is, the steps for aggregate formation or phase separation are followed here as in the case of the other dye salts. It is believed that when these dyes are so processed, for example by fuming with the solvent, the dyes themselves undergo a dye-dye interaction (rather than a dye-polymer co-crystallization) and such dyes exhibit an absorption spectrum that is thus changed.

Another subclass of useful pyrylium-type dyes is 2,4,6-trisubstituted pyrylium-type dyes salts of the general structure:

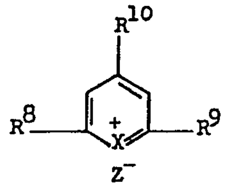

(II)

wherein $R^8$, $R^9$ and $R^{10}$ are each phenyl, substituted phenyl, alkyl containing from 1 to 6 carbon atoms, thienyl, furyl, pyridyl, pyrimidyl, thiadiazolyl, thiazolyl or pyrrolyl groups, with the proviso that at least one of the groups $R^8$, $R^9$ and $R^{10}$ is an alkylamino-substituted phenyl group which may have additional

substituents containing from 1 to 6 carbon atoms in the or each alkyl group or an alkylamino-substituted 5- or 6-membered heterocyclic ring containing from 1 to 6 carbon atoms in the or each alkyl group,

X is oxygen, selenium or sulphur; and

$Z^-$ is an anion.

The alkylamino-substituted groups which $R^8$, $R^9$ and $R^{10}$ may represent may be dialkylamino-substituted and halogenated alkylamino-substituted phenyl radicals or dialkylaminopyridyl, dialkylaminofuryl, dialkylaminothienyl or dialkylaminothiazolyl groups. Examples of such compounds, particularly wherein at least one of $R^8$, $R^9$ and $R^{10}$ is heterocyclic, are described in *Research Disclosure*, Vol. 157, May 1977, Publication No. 15742, published by Industrial Opportunities Limited, Homewell, Havant, Hampshire PO9 1EF, United Kingdom.

The dyes of structure (II) includes dyes that undergo a dye-polymer interaction to produce a discernable discontinuous phase composed of the aforementioned particulate co-crystalline complex of dye and binder dispersed within the continuous phase of binder-photoconductor when aggregate-processed.

Representative useful dye salts falling within structures (I) and (II) above are described for use in photoconductor compositions in U.S. Patent No. 3,615,414. The following Table II lists pyrylium-type dye salts which may be employed in the present invention.

TABLE II

| Number | Dye Salt |
|---|---|
| 1 | 4-(4-[bis(2-chloroethyl)amino]phenyl)-2,6-diphenylthiapyrylium perchlorate |
| 2 | 4-(4-dimethylaminophenyl)-2,6-diphenylthiapyrylium perchlorate |
| 3 | 4-(4-dimethylaminophenyl)-2,6-diphenylthiapyrylium fluoroborate |
| 4 | 4-(4-[bis(2-chloroethyl)amino]phenyl)-2-(4-methoxyphenyl)-6-phenylthiapyrylium perchlorate |
| 5 | 4-(4-dimethylaminophenyl)-2,6-diphenylthiapyrylium sulfate |
| 6 | 4-(4-dimethylaminophenyl)-2,6-diphenylthiapyrylium-p-toluenesulfonate |
| 7 | 2,6-bis(4-ethylphenyl)-4-(4-dimethylaminophenyl)thiapyrylium perchlorate |
| 8 | 4-(4-dimethylaminophenyl)-2-(4-methoxyphenyl)-6-phenylthiapyrylium perchlorate |
| 9 | 4-(4-dimethylaminophenyl)-2-(4-ethoxyphenyl)-6-phenylthiapyrylium perchlorate |
| 10 | 4-(4-diphenylaminophenyl)-2,6-diphenylthiapyrylium perchlorate |
| 11 | 2,6-bis(4-ethylphenyl)-4-(4-methoxyphenyl)thiapyrylium fluoroborate |
| 12 | 2,4,6-triphenylthiapyrylium perchlorate |
| 13 | 4-(4-methoxyphenyl)-2,6-diphenylthiapyrylium perchlorate |
| 14 | 6-(4-methoxyphenyl)-2,4-diphenylthiapyrylium perchlorate |
| 15 | 2,6-bis(4-methoxyphenyl)-4-phenylthiapyrylium perchlorate |
| 16 | 4-(2,4-dichlorophenyl)-2,6-diphenylthiapyrylium perchlorate |
| 17 | 2,4,6-tris(4-methoxyphenyl)thiapyrylium perchlorate |
| 18 | 2,6-bis(4-ethylphenyl)-4-phenylthiapyrylium perchlorate |
| 19 | 4-(4-amyloxyphenyl)-2,6-bis(4-ethylphenyl)thiapyrylium perchlorate |
| 20 | 6-(4-dimethylaminostyryl)-2,4-diphenylthiapyrylium perchlorate |
| 21 | 2,4,6-triphenylthiapyrylium fluoroborate |

TABLE II (continued)

| Number | Dye Salt |
|---|---|
| 22 | 2,4,6-triphenylthiapyrylium sulfate |
| 23 | 4-(4-methoxyphenyl)-2,6-diphenylthiapyrylium fluoroborate |
| 24 | 2,4,6-triphenylthiapyrylium chloride |
| 25 | 2-(4-amyloxyphenyl)-4,6-diphenylthiapyrylium fluoroborate |
| 26 | 4-(4-amyloxyphenyl)-2,6-bis(4-methoxyphenyl)thiapyrylium perchlorate |
| 27 | 2,6-bis(4-ethylphenyl)-4-(4-methoxyphenyl)thiapyrylium perchlorate |
| 28 | 4-anisyl-2,6-bis(4-n-amyloxyphenyl)thiapyrylium chloride |
| 29 | 2-[β,β-bis(4-dimethylaminophenyl)vinyl]-4,6-diphenylthiapyrylium perchlorate |
| 30 | 6-(β-ethyl-4-dimethylaminostyryl)-2,4-diphenylthiapyrylium perchlorate |
| 31 | 2-(3,4-diethoxystyryl)-4,6-diphenylthiapyrylium perchlorate |
| 32 | 2,4,6-trianisylthiapyrylium perchlorate |
| 33 | 2,6-bis(4-ethylphenyl)-4-(4-methoxyphenyl)thiapyrylium perchlorate |
| 34 | 2,6-bis(4-amyloxyphenvl)-4-(4-methoxyphenyl)thiapyrylium perchlorate |
| 35 | 2,6-diphenyl-4-(4-methoxyphenyl)thiapyrylium perchlorate |
| 36 | 2,6-diphenyl-4-(4-methoxyphenyl)thiapyrylium fluoroborate |
| 37 | 2,6-bis(4-ethylphenyl)-4-(4-m-amyloxyphenyl)thiapyrylium perchlorate |
| 38 | 2,6-bis(4-methoxyphenyl)-4-(4-m-amyloxyphenyl)thiapyrylium perchlorate |
| 39 | 4-[(2,6-diphenyl-4H-thiapyran-4-ylidene)methyl]-2,6-diphenylthiapyrylium perchlorate |
| 40 | 4-[(2,6-diphenyl-4H-thiapyran-4-ylidene)methyl]-2,6-diphenylselenapyrylium perchlorate |
| 41 | 4-[(2,6-diphenyl-4H-thiapyran-4-ylidene)methyl]-2,6-diphenylpyrylium fluoroborate |
| 42 | 4-[(2,6-diphenyl-4H-selenin-4-ylidene)methyl]-2,6-diphenylpyrylium fluoroborate |

The pyrylium-type dye salts employed in the present invention may be prepared by methods which are known in the art.

A wide range of organic photoconductors can be used. Preferred are organic amines such as triphenyl and tolyl amines as well as amine-substituted stilbenes and styrylstilbenes, and polyarylalkanes represented by the formula:

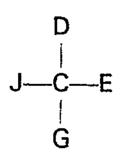

wherein each of D, E and G is an aryl group which may be substituted and J is a hydrogen atom, an alkyl group or an aryl group, with at least one of D, E and G containing an amino substituent. The aryl groups attached to the central carbon atom are preferably phenyl groups, although naphthyl groups can also be

used. Such aryl groups can contain such substituents as alkyl and alkoxy typically having 1—8 carbon atoms, hydroxy, halogen, etc., in the *ortho, meta* or *para* positions, *ortho*-substituted phenyl being preferred.

Representative photoconductors which may be used herein include those listed in Table III.

TABLE III

| Number | Photoconductor |
|---|---|
| 1 | 4,4′-benzylidenebis(N,N-diethyl-*m*-toluidene) |
| 2 | 4′,4″-diamino-4-dimethylamino-2′,2″-dimethyltriphenylmethane |
| 3 | 4′,4″-bis(diethylamino)-2,6-dichloro-2′,2″-dimethyltriphenylmethane |
| 4 | 4′,4″-bis(diethylamino)-2,2″-dimethyldiphenylnaphthylmethane |
| 5 | 2′,2″-dimethyl-4,4′,4″-tris(dimethylamino)triphenylmethane |
| 6 | 4′,4″-bis(diethylamino)-4-dimethylamino-2′,2″-dimethyltriphenylmethane |
| 7 | 4′,4″-bis(diethylamino)-2-chloro-2′,2″-dimethyl-4-dimethylaminotriphenylmethane |
| 8 | 4′,4″-bis(diethylamino)-4-dimethylamino-2,2′,2″-trimethyltriphenylmethane |
| 9 | 4′,4″-bis(dimethylamino)-2-chloro-2′,2″-dimethyltriphenylmethane |
| 10 | 4′,4″-bis(dimethylamino)-2′,2″-dimethyl-4-methoxytriphenylmethane |
| 11 | bis(4-diethylamino)-1,1,1-triphenylethane |
| 12 | bis(4-diethylamino)tetraphenylmethane |
| 13 | 4′,4″-bis(benzylethylamino)-2′,2″-methyltriphenylmethane |
| 14 | 4′,4″-bis(diethylamino)-2′,2″-diethcxytriphenylmethane |
| 15 | 4,4′-bis(dimethylamino)-1,1,1-triphenylethane |
| 16 | 1-(4-N,N-dimethylaminophenyl)-1,1-diphenylethane |
| 17 | 4-dimethylaminotetraphenylmethane |
| 18 | 4-diethylaminotetraphenylmethane |
| 19 | 4-di-*p*-tolylamino-4′-[4-(di-*p*-tolylamino)styryl]stilbene |
| 20 | 4-di-*p*-diethylaminophenylamino-4′-[4-di-(*p*-diethylaminophenylamino)styryl]stilbene |
| 21 | tri-*p*-tolylamine |
| 22 | 1,1-bis(4-di-*p*-tolylaminophenyl)cyclohexane |

It will be appreciated that almost all of the photoconductors of Table III are hole conductors or P-type conductors by themselves. However, when used in the photoconductive layer including the dye salt, certain of these photoconductors give to the photoconductive layer P-type characteristics while others give N-type characteristics.

In the case of N-type photoconductors, the efficiency can be further increased by adding an optional amount of a dopant capable of increasing the conductivity of the photoconductor. Particularly useful examples of such dopants include halogens, such as iodine, bromine, or chlorine, quinone, substituted quinones, anthraquinone and substituted anthraquinones.

The dry thickness of the photoconductive layer is an important aspect of the invention, if maximum conversion efficiencies are to be obtained. It has been found that efficiencies begin to decrease drastically for thicknesses in excess of about 0.5 micron, possibly due to increased carrier path length. Minimum thicknesses appear to be dictated more by coating techniques and the minimum

that can be used without electrically shorting out. Useful layers of improved efficiency have been constructed with thicknesses as low as about 50 nm.

The electrical conductors for the present photovoltaic elements may be selected from metals or degenerate semiconductors i.e. semiconductors whose electrical properties approach those of a metal.

It has been found that the higher efficiencies are obtained when the electrical conductors are selected with relative work functions that are sufficient to create significant rectification within the photovoltaic element for a given photoconductor. As used herein, "significant rectification" means the flow of current through the photovoltaic element in one direction is greater than in the other direction, in a ratio which is at least about 5 to 1.

Elements having higher conversion efficiencies, e.g., from 0.2 to 0.3%, are those in which the electrical conductors have the greatest difference in work functions. That is, from the materials set forth in Table IV below, two are selected to give a wide disparity in the work functions.

TABLE IV
Electrical Conductors and Work Functions

| | |
|---|---|
| indium | 3.80 |
| aluminium | 4.25 |
| silver | 4.30 |
| tin | 4.40 |
| copper | 4.40 |
| nickel | 4.50 |
| chromium | 4.60 |
| gold | 4.80 |
| Nesa (trade mark) or Nesatron (trade mark) glass | 4.8 |

Nesa and Nesatron glass comprise a semitransparent electrical conductor comprising a conductive $InSnO_4$ layer coated onto transparent glass, manufactured by PPG Industries, Inc., having a surface resistivity of 10 to 50 ohm/square and an optical transmittance of about 80%, for visible light. An alternative material is a thin transparent layer of nickel vacuum deposited on poly(ethylene terephthalate) film.

Highly preferred from the above table is the combination of indium and Nesatron glass, in view of their greatest disparity in work functions. Furthermore, Nesatron glass and the alternative nickel-coated polyester film, are transparent and transmit a high proportion of radiation incident thereon so as to provide an exposure surface for the element. Such materials are preferred for the electrical conductor through which the element is to be illuminated, hereinafter identified as the window electrical conductor. Clearly however, the other electrical conductor could be utilized as the window electrical conductor if the metal was in the form of a coating which is thin enough and carried on a transparent support.

It will be appreciated that a preferred construction of the element is one in which the electrical conductors are not only adjacent to, but are also in physical contact with, each of the surfaces of the photoconductive layer. However, this need not always be the case, because it has been found that further improvement can be achieved by optionally coating e.g., by vapor deposition, the window electrical conductor with a nucleating agent comprising copper phthalocyanine prior to coating the photoconductor. In such a case, the finished element has a very thin (about 5 nm) layer of the nucleating agent separating the photoconductive layer from the adjacent window electrical conductor. The nucleating agent appears to render more uniform, and possibly smaller, the size of the aggregate particles forming the discrete discontinuous phase, to the extent it forms at all, leading to a more uniform absorption of the light by the element.

Convenient methods of preparation of the photoconductive layer include those used to make aggregate-containing electrophotographic photoconductors, such as mixing the photoconductor in two solvents of different boiling points, so that differential evaporation rates occur upon drying, or exposing a dried coating of the photoconductor to a solvent vapor. These and other processes are described in U.S. Patents 3,615,414; 3,615,415; 3,679,407; 3,706,554 and 3,732,180.

It has been found that many of the photoconductors described above, when processed as described, demonstrate an altered absorption spectrum, e.g., a shift of an absorption peak, compared to

the absorption spectrum of an identical photoconductor which has not been subjected to such aggregate processing.

Useful methods of manufacturing the photoconductive layer include roll-coating and spin-coating techniques wherein a solution of the binder, dye salt and photoconductor in a 1:1 mixture of 1,1-dichloromethane and 1,2-dichloroethane is poured onto the conducting surface of a clean Nesatron glass electrical conductor while the latter is spun at about 1000 to 5000 rpm until a wet thickness is achieved which dries down to a thickness no greater than about 0.5 micron. Subsequently, a vapor treatment for 1—5 minutes in an appropriate solvent vapor can be utilized to aggregate-process the dye salt and binder in the photoductive layer. Solvents which may be used for the vapor treatment include, toluene, xylene, chlorobenzene, 1,2-dichlorobenzene, bromobenzene, dichloromethane and 1,2-dichloroethane. The opposite electrical conductor is then preferably applied by conventional vapor deposition. Such electrical conductor can be coextensive with the contacting surface of the photoconductive layer, but it can also cover only a fraction of the surface.

The cleanliness of the Nesatron glass electrical conductor can be achieved by any convenient polishing technique. A currently preferred polishing process comprises the steps of rubbing the Nesatron glass with a cotton flannel wetted with a suspension of an alumina or other abrasive, or by polishing in a spinning disc, usually for a few minutes. The polished Nesatron glass electrical conductor is then cleaned in a 1:1 $H_2O$/isopropyl alcohol ultrasonic bath for about half an hour to remove the abrasive particles, and then rinsed thoroughly with distilled water. The polished Nesatron glass electrical conductor appears relatively clear in a strong light.

The concentrations of photoconductor and binder of the photoconductive layer are preferably such as to provide approximately equal weight amounts of organic photoconductor and binder, with no more than 50% of total solids being the binder, and sufficient amounts of dye salt to produce an optical density up to about 1.0. Highly useful dye salt concentrations produce an optical density between 0.3 and 0.6. Representative amounts of dye salt to produce such optical densities range between 3 and 40 weight percent of the total dried solids weight of the photoconductive layer, depending upon the extinction coefficient of the dye salt and the thickness of the layer. The preferred range for the dye salts of Table II is from 5 to 20 weight percent.

Total coverage of the photoconductive layer can range from 0.2 mg/dm$^2$ to 20 mg/dm$^2$, and preferably from 0.5 mg/dm$^2$ to 4 mg/dm$^2$. Preferred solvents for the solutions to be spin-coated include dichloromethane, 1,2-dichloroethane and 1:1 mixtures of these two.

Elements made in accordance with the preceding description can be illuminated by sunlight or by artificial light. In the case of light rich in UV, preferred usage interposes a filter excluding light of wavelengths less than about 500 nm., as UV radiation can cause premature degradation of the element.

The following examples illustrate the practice of the invention.

Example 1

An organic photovoltaic element was fabricated as follows:

A photoconductive layer coating solution containing 1.4% by weight of solids in a mixed solvent of 1,1-dichloromethane and 1,2-dichloroethane (in 1:1 weight ratio) was prepared by sequentially dissolving in 40 g. of the mixed solvent 112 mg. of a thiapyrylium dye salt, 2,6 - diphenyl - 4 - (4 - dimethylaminophenyl)thiapyrylium hexafluorophosphate, 294 mg. of a binder, high-molecular weight Bisphenol A polycarbonate having an inherent viscosity of about 2.3 and 294 mg. of an organic photoconductor, 4 - di - *p* - tolylamino - 4′ - [4 - (di - *p* - tolylamino)styryl]stilbene.

A clean piece of Nesatron glass about 2.5 cm x 2.5 cm was spun on a turntable at about 2000 rpm. While spinning, a small quantity (about 0.5 ml.) of the coating solution was poured on the conducting surface of the Nesatron glass. A thin and apparently uniform photoconductive layer was obtained upon evaporation of the solvent. The thickness of the dry layer was about 200 nm.

The spin-coated film was then subjected to vapor treatment by a toluene vapor to induce aggregation of the thiapyrylium dye and the Bisphenol A polycarbonate polymer. Vapor treatment for 2 minutes was sufficient to induce essentially complete aggregation.

To complete the fabrication, an evaporated layer of indium having an area of 1 cm$^2$ was applied on top of the aggregated coating.

The photovoltaic element was illuminated through the semitransparent Nesatron glass electrical conductor with a broad-band illumination of 100 mW/cm$^2$ intensity provided by an unmodified slide projector containing a tungsten light source and filtered through a filter, which cuts off light of wavelength shorter than 500 nm. The open-circuit voltage developed between the Nesatron glass and the indium electrical conductors was 800 mV and the short-circuit current was 1.0 mA/cm$^2$. The maximum power delivered to a resistive load of 1000ohms was about 0.2 mW/cm$^2$, representing a power conversion efficiency of 0.2%.

Example 2

The element described in Example 1 was illuminated through the Nesatron glass electrical conductor with monochromatic light of wavelength 670 nm. and of intensity 0.66 mW/cm$^2$, produced

by intercepting the tungsten light of Example 1 with interference filters with bandwidths of about 10 nm. This illumination produced an open-circuit voltage of 740 mV and a short-circuit current of 62 $\mu A/cm^2$. The power conversion efficiency under such monochromatic illumination was 2.5%. The collection efficiency, i.e., charge carriers produced per photon incident on the element was about 17%.

Example 3

A photovoltaic element was prepared as described in Example 1 except that the photoconductive layer had the following formulation: 42% high-molecular-weight Bisphenol A polycarbonate polymer binder, 16% 2,6 - diphenyl - 4 - (4 - dimethylaminophenyl)thiapyrylium hexafluorophosphate pyrylium dye salt and 42% tritolylamine photoconductor. Under a broad-band illumination of intensity 100 $mW/cm^2$ provided by an unmodified slide projector containing a tungsten light source filtered through a filter which cuts off light of wavelength shorter than 500 nm, the element produced an open-circuit voltage of 800 mV, a short-circuit current of 240 $\mu A/c.^2$ and a conversion efficiency of 0.05%.

Example 4

An element was prepared as described for Example 1, except that 16% by weight of the photoconductive layer coating composition was the dye salt, 4 - [2,6 - diphenyl - 4H - thiapyran - 4 - ylidene)methyl] - 2,6 - diphenylthiapyrylium perchlorate. Such an element yielded a simulated sunlight conversion efficiency of 0.13% with an open-circuit voltage of 520 mV and a short circuit current of 0.85 $mA/cm^2$.

Example 5

Preparation of the element of Example 1 was repeated, except that prior to spin-coating the photoconductive layer a vapor deposited coating of copper phthalocyanine (5—10 nm) was first applied as a nucleating agent. The resultant photoconductive layer was much more uniform with an aggregate particle size of 0.3 to 0.4$\mu$ compared with the aggregate particle size of about 10$\mu$ for the layer without the nucleating copper phthalocyanine layer. With such a two-layer system the element yielded a conversion efficiency of 0.38% under a simulated sunlight of 75 $mW/cm^2$ intensity.

Example 6

A photovoltaic element was prepared as described in Example 1, but the photoconductive layer had the following formulation, by weight:

42% high-molecular-weight Bisphenol A polycarbonate polymer binder
16% 4 - [2,6 - diphenyl - 4H - thiapyran - 4 - ylidene)methyl] - 2,6 - diphenylthiapyrylium perchlorate pyrylium dye salt and
42% 4 - di - p - tolylamino - 4′ - [4 - di - p - tolylamino)styryl] - stilbene photoconductor.

Under broad-band illumination of 100 $mW/cm^2$ intensity provided by an unmodified slide projector provided with a tungsten light source and filtered through the filter used in Example 1, the element with Nesatron glass and indium as electrical conductors produced an open-circuit voltage of 400 mV, a short-circuit current of 0.75 $mA/cm^2$, and a power conversion efficiency of about 0.09%.

**Claims**

1. A photovoltaic element which comprises a photoconductive layer comprising an electrically insulating binder, a pyrylium-type dye salt and an organic photoconductor having an electrical conductor adjacent each of the surfaces of the layer, at least one of the conductors being transparent to electro magnetic radiation to which the element is sensitive.

2. An element as claimed in claim 1 wherein said photoconductive layer is P-type, one of said conductors is a layer of indium, aluminium, magnesium, tin, chromium, copper or silver, and the other of said conductors is a transparent layer of indium tin oxide, tin oxide or nickel coated over a transparent support.

3. An element as claimed in claim 1 wherein said layer is N-type, one of said conductors is a layer of indium, aluminium, magnesium, tin, chromium, copper or silver, and the other of said conductors is a transparent layer of indium tin oxide, tin oxide or nickel coated over a transparent support.

4. An element as claimed in claim 1 or 3 wherein said photoconductive layer is N-type and includes a conductivity-increasing dopant dispersed throughout said layer.

5. An element as claimed in any of claims 1—4 which includes a nucleating layer of copper phthalocyanine between said layer and one of said conductors.

6. An element as claimed in any of claims 1—5 wherein said dye salt has the structure:

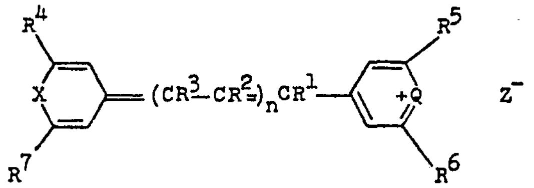

(I)

wherein

$R^1$, $R^2$ and $R^3$ are the same or different and are each hydrogen atoms or, aryl, substituted aryl, alkyl containing from 1 to 6 carbon atoms, cyano or nitro groups,

X and Q are the same or different and are each oxygen, sulphur or selenium atoms,

n is 1 or 0,

$R^4$, $R^5$, $R^6$ and $R^7$ are the same or different and are each a phenyl or substituted phenyl group or an alkyl or alkoxy group containing from 1 to 5 carbon atoms, at least two of the groups $R^4$, $R^5$, $R^6$ and $R^7$ being phenyl groups, and

$Z^-$ is an anion.

7. An element as claimed in any of claims 1—5 wherein said dye salt has the structure:

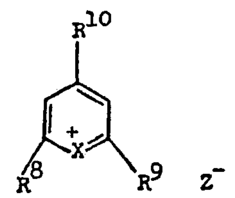

(II)

wherein $R^8$, $R^9$ and $R^{10}$ are each phenyl, substituted phenyl, alkyl containing from 1 to 6 carbon atoms, thienyl, furyl, pyridyl, pyrimidinyl, thiadiazolyl, thiazolyl or pyrrolyl groups with the proviso that at least one of the groups $R^8$, $R^9$ and $R^{10}$ is an alkylamino-substituted phenyl group which may have additional substituents containing from 1 to 6 carbon atoms in the or each alkyl group or an alkylamino-substituted 5- or 6-membered heterocyclic ring containing from 1 to 6 carbon atoms in the or each alkyl group,

X is oxygen, selenium or sulphur; and

$Z^-$ is an anion.

8. An element as claimed in any of claims 1—7 wherein the photoconductive layer comprises a binder having an alkylidenediarylene portion in a recurring unit thereof.

9. An element as claimed in any of claims 1—8 wherein the photoconductive layer is a multiphase organic solid having a continuous phase including said binder and said photoconductor and a discontinuous phase including the dye salt and the binder.

10. An element as claimed in any of claims 1—9 wherein the photoconductive layer has a thickness no greater than 0.5 micron.

**Patentansprüche**

1. Photovoltasches Element mit einer photoleitfähigen Schicht mit einem elektrisch isolierenden Bindemittel, einem Farbstoffsalz vom Pyryliumtyp und einem organischen Photoleiter sowie an beide Oberflächen der photoleitfähigen Schicht angrenzenden elektrischen Leitern, von denen mindestens einer für die elektromagnetische Strahlung durchlässig ist, der gegenüber das Element empfindlich ist.

2. Element nach Anspruch 1, in dem die photoleitfähige Schicht vom P-Typ ist, einer der Leiter aus einer Schicht aus Indium, Aluminium, Magnesium, Zinn, Chrom, Kupfer oder Silber besteht und der andere Leiter aus einer transparenten Schicht aus Indiumzinnoxid, Zinnoxid oder Nickel besteht, die auf einen transparenten Träger aufgetragen ist.

3. Element nach Anspruch 1, in dem die photoleitfähige Schicht vom N-Typ ist, einer der Leiter aus einer Schicht aus Indium, Aluminium, Magnesium, Zinn, Chrom, Kupfer oder Silber besteht und der andere Leiter aus einer transparenten Schicht aus Indiumzinnoxid, Zinnoxid oder Nickel besteht, die auf einen transparenten Träger aufgetragen ist.

4. Element nach Ansprüchen 1 oder 3, in dem die photoleitfähige Schicht vom N-Type ist und in der Schicht ein die Leitfähigkeit erhöhendes Dotiermittel dispergiert ist.

5. Element nach einem der Ansprüche 1 bis 4, in dem zwischen der photoleitfähigen Schicht und einem der Leiter eine Kupferphthalocyanin-Keimschicht angeordnet ist.

6. Element nach einem der Ansprüche 1 bis 5, in dem das Farbstoffsalz der folgenden Struktur entspricht:

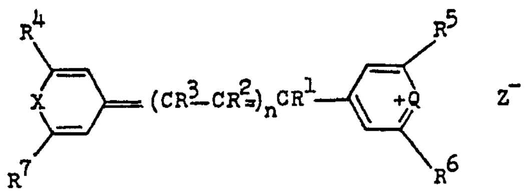

(I)

worin bedeuten:

$R^1$, $R^2$ und $R^3$, die die gleiche oder eine voneinander verschiedene Bedeutung haben können, jeweils ein Wasserstoffatom oder eine Aryl-, substituierte Aryl-, Alkyl- mit 1 bis 6 Kohlenstoffatomen, Cyano- oder Nitrogruppe,

X und Q, die die gleiche oder eine voneinander verschiedene Bedeutung haben können, jeweils ein Sauerstoff-, Schwefel- oder Selenatom,

n = 1 oder 0,

$R^4$, $R^5$, $R^6$ und $R^7$, die die gleiche oder eine voneinander verschiedene Bedeutung haben können, jeweils eine Phenyl- oder substituierte Phenylgruppe oder eine Alkyl- oder Alkoxygruppe mit 1 bis 5 Kohlenstoffatomen, wobei mindestens zwei der Gruppen $R^4$, $R^5$, $R^6$ und $R^7$ Phenylgruppen sind, und

$Z^-$ ein Anion.

7. Element nach einem der Ansprüche 1 bis 5, in dem das Farbstoffsalz der folgenden Struktur entspricht:

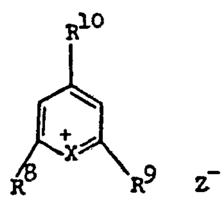

(II)

worin bedeuten:

$R^8$, $R^9$ und $R^{10}$ jeweils eine Phenyl- substituierte Phenyl-, Alkyl- mit 1 bis 6 Kohlenstoffatomen, Thienyl-, Furyl-, Pyridyl-, Pyrimidyl-, Thiadiazolyl-, Thiazolyl- oder Pyrroly- gruppe, wobei gilt, daß mindestens eine der Gruppen $R^8$, $R^9$ und $R^{10}$ eine Alkylamino-substituierte Phenylgruppe, die noch zusätzliche Substituenten mit 1 bis 6 Kohlenstoffatomen in der oder jeder Alkylgruppe aufweisen kann, oder ein Alkylaminosubstituierter 5- oder 6-gliedriger heterocyclischer Ring mit 1 bis 6 Kohlenstoffatomen in der oder jeder Alkylgruppe ist,

X = Sauerstoff, Selen oder Schwefel und

$Z^-$ ein Anion.

8. Element nach einem der Ansprüche 1 bis 7, in dem die photoleitfähige Schicht ein Bindemittel mit wiederkehrenden Einheiten mit einem Alkylidendiarylenteil aufweist.

9. Element nach einem der Ansprüche 1 bis 7, in dem die photoleitfähige Schicht eine mehrphasige organische feste Masse mit einer kontinuierlichen Phase aus dem Bindemittel und dem Photoleiter und einer diskontinuierlichen Phase aus dem Farbstoffsalz und dem Bindemittel ist.

10. Element nach einem der Ansprüche 1 bis 9, in dem die photoleitfähige Schicht eine Dicke von nicht mehr als 0,5 Mikron aufweist.

**Revendications**

1. Elément photovoltaïque qui comprend une couche photoconductrice contenant un liant électriquement isolant, un sel de colorant de type pyrylium et un photoconducteur organique ayant un conducteur électrique adjacent à chacune des faces de la couche photoconductrice, au moins l'un de ces conducteurs étant transparent au rayonnement électromagnétique auquel l'élément est sensible.

2. Elément conforme à la revendication 1 dans lequel la couche photoconductrice est une couche de type P, l'un des dits conducteurs est une couche d'indium, d'aluminium, de magnésium, d'étain, de chrome, de cuivre ou d'argent et l'autre des dits conducteurs est une couche transparente d'oxyde d'étain et d'indium, d'oxyde d'étain ou de nickel déposée sur un support transparent.

3. Elément conforme à la revendication 1, dans lequel la couche photoconductrice est de type N, l'un des dits conducteurs est une couche d'indium, d'aluminium, de magnésium, d'étain, de chrome, de cuivre ou d'argent et l'autre des dits conducteurs est une couche transparente d'oxyde d'étain et d'indium, d'oxyde d'étain ou de nickel déposée sur un support transparent.

4. Elément conforme à la revendication 1 ou 3, dans lequel la couche photoconductrice est une couche de type N et comprend un dopant pour augmenter la conductivité dispersé au sein de la couche.

5. Produit conforme à l'une des revendications 1 à 4 qui comprend une couche de nucléation de phtalocyanine de cuivre entre la dite couche photoconductrice et l'un des conducteurs.

6. Produit conforme à l'une des revendications 1 à 5 dans lequel le sel de colorant a la structure:

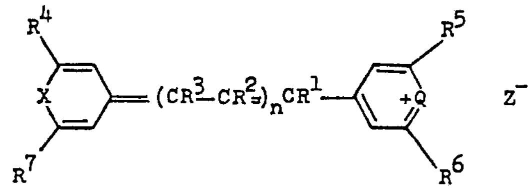

(I)

où $R^1$, $R^2$ et $R^3$ sont identiques ou différents et sont chacun des atomes d'hydrogène ou, des groupes aryle, aryle substitué, alkyle contenant de 1 à 6 atomes de carbone, cyano ou nitro.

X et Q sont identiques ou différents et sont chacun des atomes d'oxygène, de soufre ou de sélénium,

*n* est égal à 1 ou 0,

$R^4$, $R^5$, $R^6$ et $R^7$ sont identiques ou différents et représentent chacun un groupe phényle ou phényle substitué ou un groupe alkyle ou alkoxy contenant de 1 à 5 atomes de carbone, au moins deux des groupes $R^4$, $R^5$, $R^6$ et $R^7$ étant des groupes phényle et

$Z^-$ est un anion.

7. Elément conforme à l'une des revendications 1 à 5, dans lequel le sel de colorant a la structure:

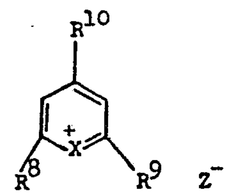

(II)

où $R^8$, $R^9$ et $R^{10}$ sont chacun un groupe phényle, phényle substitué, alkyle contenant de 1 à 6 atomes de carbone, thiényle, furyle, pyridyle, pyrimidinyle, thiadiazolyle, thiazolyle ou pyrrolyle, au moins l'un des groupes $R^8$, $R^9$ et $R^{10}$ étant un radical phényle porteur d'un substituant alkyl amino qui peut porter des substituants supplémentaires et qui contient de 1 à 6 atomes de carbone dans le ou chaque groupe alkyle, ou un hétérocycle à 5 ou 6 atomes substitué par un groupe alkyl amino qui contient de 1 à 6 atomes de carbone environ dans le ou chaque groupe alkyle

X est un atome d'oxygène, de sélénium ou de soufre et,

$Z^-$ est un anion.

8. Elément conforme à l'une des revendications 1 à 7 dans lequel la couche photoconductrice comprend un liant ayant un motif comprenant un groupe alkylidène-diarylène.

9. Elément conforme à l'une des revendications 1 à 8 dans lequel la couche photoconductrice est constituée par un solide organique à plusieurs phases comprenant une phase continue qui contient le dit liant et une phase discontinue qui contient le sel de colorant et le liant.

10. Elément conform à l'une des revendications 1 à 9 dans lequel l'épaisseur de la couche photoconductrice n'est pas supérieure à 0,5 micron.